(19) Europäisches Patentamt
European Patent Office
Office européen des brevets

(11) **EP 4 507 159 A2**

(12) **EUROPEAN PATENT APPLICATION**
published in accordance with Art. 153(4) EPC

(43) Date of publication:
**12.02.2025 Bulletin 2025/07**

(51) International Patent Classification (IPC):
**H02J 7/00** (2006.01)   **G01R 31/3835** (2019.01)
**G01R 31/389** (2019.01)

(21) Application number: 23889159.2

(22) Date of filing: 08.11.2023

(52) Cooperative Patent Classification (CPC):
**G01R 31/3835; G01R 31/389; H02J 7/00;**
Y02E 60/10

(86) International application number:
**PCT/KR2023/017917**

(87) International publication number:
**WO 2024/101901 (16.05.2024 Gazette 2024/20)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **08.11.2022 KR 20220147912**

(71) Applicant: **LG Energy Solution, Ltd.**
**Seoul 07335 (KR)**

(72) Inventors:
• **YOON, Yeo Kyung**
  **Daejeon 34122 (KR)**
• **KIM, Yong Jun**
  **Daejeon 34122 (KR)**

(74) Representative: **Plasseraud IP**
**104 Rue de Richelieu**
**CS92104**
**75080 Paris Cedex 02 (FR)**

(54) **BATTERY MANAGEMENT SYSTEM, BATTERY PACK INCLUDING SAME, AND METHOD OF ESTABLISHING CHARGING PROTOCOL OF LITHIUM SECONDARY BATTERY**

(57)     A charging protocol establishment method and battery management system of a lithium secondary battery according to the present invention, wherein, for a two-electrode battery cell, a closed-circuit voltage ($CCV_{SOCx}$) and an open-circuit voltage ($OCV_{SOCx}$) according to a state of charge (SOCx) during charging with each charging current (I) are measured according to Equation 1 below, and by collecting an internal resistance profile plotting the internal resistance value ($R_{SOCx}$) according to the state of charge for each charge current (I), a limit state of charge corresponding to each charge current is determined from the internal resistance profile.

[Equation 1]

Internal resistance value according to state of charge $(R_{SOCx}) = (CCV_{SOCx} - OCV_{SOCx})/I$

EP 4 507 159 A2

[FIG. 3]

**Description**

[Technical Field]

This application claims the benefit of priority to Korean Patent Application No. 10-2022-0147912, filed on Nov. 8, 2022.

The present invention relates to a method for establishing a quick charging protocol that reflects heat generation and internal resistance due to charging and discharging of a large capacity battery cell, a battery management system capable of establishing such a quick charging protocol, and a battery pack including the same.

[Background Technology of the Invention]

In recent years, the demand for portable electronic products such as laptops and portable phones has increased dramatically, and the demand for electric carts, electric wheelchairs, and electric bicycles has also increased, and research on high-performance batteries that can be repeatedly charged and discharged has been actively conducted. In recent years, the demand for hybrid electric vehicles (HEVs) and electric vehicles (EVs) has also been increasing worldwide as carbon energy is gradually depleting and environmental concerns are rising. As a result, more attention and research are being focused on vehicle batteries, which are the core components of HEVs and EVs, and there is an urgent need to develop quick charging technologies that can quickly recharge batteries. Quick charging is a critical capability, especially for EVs that do not have an additional energy source.

The process of charging a battery involves introducing current into the battery to build up charge and energy, and this process must be carefully controlled. In general, excessive charging current (C-rate) or charging voltage can permanently age the performance of a battery and ultimately cause complete failure, or cause a sudden failure such as a leak or explosion of highly corrosive chemicals.

When charging a battery with a constant current, if the current rate of the charging current is small, a very long time is required to fully charge the battery. On the other hand, if the current rate of the charging current is too high, the battery will quickly age. Therefore, during constant current charging, it is necessary to gradually adjust the current rate of the charging current according to the state of the battery.

A charge map with a "multi-stage constant-current charging protocol" is often utilized to adjust the current rate during constant-current charging in a stepwise manner. The charge map includes at least one data array in which a relationship between a plurality of current rates and a plurality of transition conditions is recorded. Whenever each transition condition is satisfied, the following sequence of current rates can be supplied to the battery as charging current. A current rate (which may also be referred to as a 'C-rate') is the charging current divided by the maximum capacity of the battery, using the unit 'C'.

Conventionally, to derive such a multi-stage constant-current charging protocol, a 50mAh mono-cell type three-electrode cell was manufactured, and the state of charge (SOC) at which Li-plating occurs at the negative electrode for each charging current was established as the charging limit.

However, three-electrode cells are difficult to manufacture and require a dedicated charger and discharger to charge and discharge, so there are many constraints such as the completeness of the three-electrode cell, the manufacturing time of the three-electrode cell, the preparation of the dedicated charger and discharger, and the like. In addition, when applying the limit state of charge identified in these three-electrode cells to large capacity battery cells with capacities in the range of 40-200 Ah, there is no technology that reflects the resistance of large capacity battery cells or the heat generation during quick charging. In addition, the method of establishing charging protocols using three-electrode cells is subject to the experimenter's subjectivity as the Li-plating zones are not clearly distinguished as the charging current becomes smaller and as the negative electrode composition becomes more favorable for quick charging, making it difficult to establish charging protocols that exhibit similar voltage profiles in case of deviations in the battery cells.

Therefore, it is necessary to develop a technology eliminates the need to manufacture a three-electrode cell and derive a charging protocol that can produce similar voltage profiles in the presence of battery cell variations, while considering the resistance of large capacity battery cells and the heat generation state during quick charging.

[Description of the Invention]

[Technical Problem]

The present invention is designed to solve the above problems, and aims to provide a method for deriving a charging protocol that does not require manufacturing a three-electrode cell in advance to derive a limit state of charge by charging current, a method for deriving a charging protocol that considers the resistance of a large capacity battery cell and the heat generation state during quick charging, and a battery management system capable of establishing such a charging protocol, and a battery pack mounting the same.

[Technical Solution]

According to one embodiment of the present invention, a battery management system is provided. The battery management system includes, a measurement portion configured to measure, for a two-electrode battery cell having a positive electrode and a negative electrode, a closed circuit voltage ($CCV_{SOCx}$) and an open circuit voltage ($OCV_{SOCx}$), respectively, according to a state of charge (SOCx), when charged with different charging currents (I); a memory portion configured to collect and store internal resistance profiles plotting the internal resistance value ($R_{SOCx}$) according to the state of charge for each charging current (I), by substituting the measured $CCV_{SOCx}$ and $OCV_{SOCx}$ into Equation 1 below to calculate the internal resistance value ($R_{SOCx}$) according to the state of charge; and a control portion configured to determine, from the internal resistance profiles, limit state of charges corresponding to each charging current, and to establish a charging protocol based thereon.

Internal resistance value according to state of charge $(R_{SOCx})=(CCV_{SOCx} - OCV_{SOCx})/I$ [Equation 1]

In exemplary embodiments, the control portion may be configured to determine a state of charge (SOCx) value, as a limit state of charge, at a point where the graphical shape of the internal resistance profile changes from flat to a downward trend.

In exemplary embodiments, the control portion may be configured to re-establish the charging protocol by periodically, during repeated charging and discharging of the battery cells, deriving new limit state of charges corresponding to each charging current.

In exemplary embodiments, the battery management system further includes a connecting portion configured to connect with a charging device to supply a charging current to the battery cell according to a charging protocol established by the control portion.

In exemplary embodiments, the measurement portion is configured to measure a status information of the battery cell comprising at least one of a voltage of the battery cell and a state of charge.

In exemplary embodiments, the charging current (I) is selected from a range of 0.33C to 6.0C.

According to another exemplary embodiments of the present invention, a battery pack is provided. The battery pack includes the above-mentioned battery management system.

In exemplary embodiments, the battery pack may include a plurality of battery cells having a capacity of 40 to 200 Ah.

According to another exemplary embodiments of the present invention, a method for establishing a lithium secondary battery charging protocol is provided. The method for establishing a lithium secondary battery charging protocol includes: (a) measuring the closed circuit voltage ($CCV_{SOCx}$) and open circuit voltage ($OCV_{SOCx}$) according to the state of charge (SOCx), respectively, for a two-electrode battery cell with a positive electrode and a negative electrode, when charged with different charging currents (I);

(b) substituting the measured $CCV_{SOCx}$ and $OCV_{SOCx}$ into Equation 1 below to calculate an internal resistance value ($R_{SOCx}$) according to the state of charge, and collecting internal resistance profiles plotting the internal resistance value ($R_{SOCx}$) according to the state of charge, for each charging current (I); and

(c) determining, from the collected internal resistance profiles, limit state of charges corresponding to each charging current;

Internal resistance value according to state of charge $(R_{SOCx})=(CCV_{SOCx} - OCV_{SOCx})/I$ [Equation 1]

In exemplary embodiments, in process (c), the limit state of charge is determined as a state of charge (SOC) value at a point where the graphical shape of the internal resistance profile changes from flat to a downward trend.

In exemplary embodiments, the two-electrode battery cell has a capacity of 40 to 200 Ah.

In exemplary embodiments, in process (a), the charging current (I) is selected from the range of 0.33C to 6.0C.

In exemplary embodiments, in process (a), the charging current (I) is set at an interval of 0.1C to 1.0C.

A method for establishing a charging protocol according to exemplary embodiments further includes mapping a charging protocol based on a limit state of charge by charging current, wherein the mapping process maps so that each charging current is charged at a corresponding charging current up to a limit state of charge, but the charging current decreases as the state of charge increases.

[Advantageous Effects]

The battery management system and charging protocol setting method according to the present invention have the effect of providing a charging protocol that reflects the resistance and heat generation directly from a large capacity battery cell, without the need to manufacture a three-electrode cell, which is cumbersome to manufacture.

Furthermore, the battery management system and the charging protocol setting method according to the present invention have the effect of non-destructively identifying the degree of degeneration of a battery cell even during operation of the battery cell, and updating the charging protocol to reflect the degeneration of the battery cell.

Furthermore, the battery management system and charging protocol setting method according to the present invention can derive a limit state of charge even at a charging current as low as 1.0C, thereby providing a charging protocol favorable for quick charging.

[Brief Description of the Drawings]

FIG. 1 is a diagram illustrating an exemplary configuration of a battery pack including a battery management system according to an exemplary embodiment of the present invention.

FIG. 2 is a diagram schematically illustrating of a battery pack including a battery management system according to an exemplary embodiment of the present invention.

FIG. 3 is an internal resistance profile, by charging current (I), collected according to an exemplary embodiment of the present invention.

FIG. 4 is a graph illustrating the limit state of charge by charging current derived according to the present invention and prior art method of establishing charging protocol.

FIG. 5 is a SOC-OCV profile for each of the battery cells charged with a charging protocol established according to the present invention and prior art method.

FIG. 6 is a flowchart of a method for establishing a charging protocol for a lithium secondary battery according to an exemplary embodiment of the present invention.

FIG. 7 is an internal resistance profile by charging current (I), collected according to an exemplary embodiment of the present invention, for a degenerated battery cell that has undergone 500 charge and discharge cycles.

FIG. 8 is a graph showing the limit state of charge by charging current (I) of FIG. 4 and the limit state of charge by charging current (I) of the degenerated battery cell of FIG. 7.

[Best Mode for Carrying out the Invention]

The terms and words used in this specification and claims are not to be construed in their ordinary or dictionary sense, but are to be construed in a sense and concept consistent with the technical idea of the present invention, based on the principle that the inventor may properly define the concept of a term to best describe his invention.

Accordingly, it is to be understood that the embodiments described herein and the configurations illustrated in the drawings are only the most preferred embodiments of the present invention and do not represent all of the technical ideas of the present invention, and that there may be various equivalents and variations that may be substituted for them at the time of filing the application.

In addition, in describing the invention, detailed descriptions of related known configurations or features are omitted where it is determined that such detailed descriptions would obscure the essence of the present invention.

Throughout the specification, when a part is said to "include" a component, it means that it may further include other components, not that it excludes other components, unless specifically stated to the contrary.

In addition, terms such as control portion as used in the specification refer to a unit that handles at least one function or operation, which may be implemented in hardware or software, or a combination of hardware and software.

In addition, throughout the specification, when a part is said to be "connected" to another part, this includes not only "directly connected" but also "indirectly connected" with other elements in between.

Hereinafter, preferred embodiments of the present invention will be described in detail with reference to the accompanying drawings.

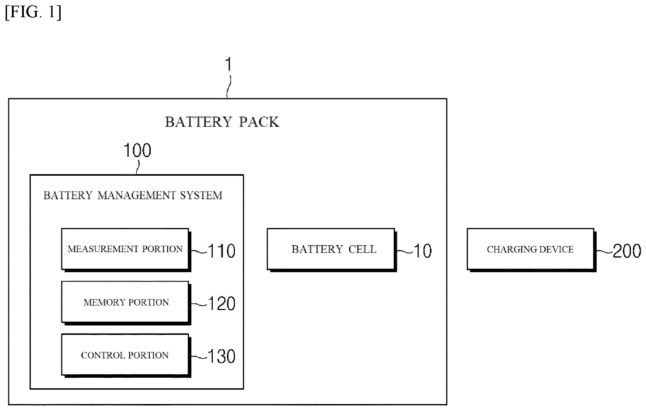

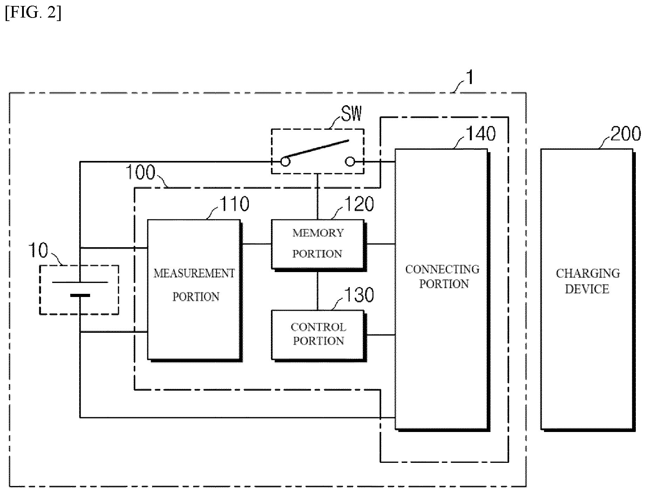

FIG. 1 is a diagram illustrating an exemplary configuration of a battery pack including a battery management system according to an exemplary embodiment of the present invention. FIG. 2 is a diagram schematically illustrating of a battery pack including a battery management system according to an exemplary embodiment of the present invention.

Referring to FIG. 1, a battery pack 1 may include a battery cell 10 and a battery management system 100. The battery management system 100 is a battery management system that monitors the voltage, current, temperature, and the like of the battery cell 10 to control and manage them to prevent overcharging, overdischarging, and the like.

Here, the battery cell 10 is a two-electrode battery cell having a negative electrode and a positive electrode, which is a single, physically separable cell. In one example, a pouch-type lithium polymer cell may be considered as a battery cell 10. Further, the battery cell 10 may be a large capacity battery cell having a capacity in the range of 40 to 200 Ah.

The battery pack 1 may also include a battery module with one or more battery cells 10 connected in series and/or parallel.

As a positive electrode active material comprising the positive electrode of the battery cell 10, a lithium-containing transition metal oxide may be used. For example, $LiCoC_2$, $LiNiO_2$, $LiMnO_2$, $LiMn_2O_4$, $Li(Ni_aCo_bMn_c)O_2$ ($0<a<1,0<b<1$, $0<c<1$, $a+b+c=1$), $Li_x(Ni_aCo_bMn_cAl_d)O_2$($0.5<x<1.3$, $0.6<a<1$, $0<b<0.2$, $0<c<0.1$, $0<d<0.1$, $a+b+c+d=1$), $LiNi_{1-y}Co_yO_2$, $LiCo_{1-y}Mn_yO_2$, $LiNi_{1-y}Mn_yO_2$($0 \leq y<1$), $Li(Ni_aCo_bMn_c)O_4$($0<a<2$, $0<b<2,0<c<2$, $a+b+c=2$), $LiMn_{2-z}Ni_zO_4$, $LiMn_{2-z}Co_zO_4$ ($0<z<2$), $LiCoPO_4$, $LiFePO_4$, or two or more of these may be used. In addition to these oxides, it may also be a sulfide, a selenide, a halide, and the like.

As a negative electrode active material that comprises the negative electrode, a carbon-based material such as graphite or activated carbon, or a material such as silicon oxide ($SiO_x$) is being used.

For negative electrode active materials using carbon-based materials, the potential is very low, similar to that of Li, so that an increase in resistance or an increase in current will cause Li-plating, which forms a metal-coated film on the negative electrode due to the nature of the lithium ions. Therefore, a safe charging protocol is established by defining the state of charge at which Li-plating occurs at the negative electrode as the limit state of charge.

In establishing a quick charging protocol, the present invention derives the Li-plating point at which a limit state of charge is set from an internal resistance profile that plots the internal resistance values according to the state of charge of the battery cell.

Referring to FIG. 1, a battery management system 100 according to the present invention may include a measurement portion 110, a memory portion 120, and a control portion 130.

In the embodiment of FIG. 2, the battery management system 100 according to the present invention may further include a connecting portion 140 configured to connect with a charging device 200 capable of supplying charging current to the battery cell, according to a charging protocol established by the control portion 130.

The charging device 200 may be connected with the battery pack 1. And, the charging device 200 connected with the battery pack 1 may supply a charging current to the battery cell 10 according to a charging protocol established by the control portion 130 for the battery cell 10.

And, the battery management system 100 may control the operation of the switching portion SW to control the charging and discharging of the battery cells 10 and/or battery modules.

The measurement portion 110 is configured to measure status information of the battery cell, which includes at least one of a voltage and a state of charge for the battery cell 10. The measurement portion 110, according to an embodiment of the present invention, is configured to measure a closed circuit voltage ($CCV_{SOCx}$) according to a state of charge (SOCx) and an open circuit voltage ($OCV_{SOCx}$) according to a state of charge (SOCx), respectively, for calculating an internal resistance value of the battery cell 10. The values of the closed circuit voltage ($CCV_{SOCx}$) and the open circuit voltage ($OCV_{SOCx}$) measured by the measurement portion 110 are the basis data for calculating the internal resistance value at the corresponding state of charge (SOCx).

The measurement portion 110 is configured to measure, for the battery cell 10, a closed circuit voltage ($CCV_{SOCx}$) and an open circuit voltage ($OCV_{SOCx}$), respectively, according to the state of charge, at different charging currents (I). In exemplary embodiments, the charging current (I) may be plurally selected within a range of 0.2C to 6C, more specifically 0.33C to 6C, and more specifically 0.5C to 5C. Furthermore, the interval of the charging current (I) may be set at an interval of 0.1C to 1.0C. For example, for the battery cell 10, with a charging current (I) of various values set at intervals of 0.25C, such as 0.25C - 0.5C - 0.75C... - 2.75C - 3.0C, charging is performed up to SOC 100%, and the measurement portion 110 is configured to measure the closed circuit voltage ($CCV_{SOCx}$) and the open circuit voltage ($OCV_{SOCx}$) according to the state of charge (SOCx) at each charging current (I), wherein each measuring point of the closed circuit voltage ($CCV_{SOCx}$) and the open circuit voltage ($OCV_{SOCx}$) may be set at a SOC 2.5% interval, at a SOC 5% interval, or at a SOC 10% interval.

The memory portion 120 is configured to calculate the internal resistance value $R_{SOCx}$ according to the state of charge SOCx by substituting the $CCV_{SOCx}$ and the $OCV_{SOCx}$ measured by the measurement portion 110 into the Equation 1 below, and to collect and store an internal resistance profile plotting the internal resistance value $R_{SOCx}$ according to the state of charge for each charging current I.

$$\text{Internal resistance value according to state of charge } (R_{SOCx})=(CCV_{SOCx} - OCV_{SOCx})/I \qquad \text{[Equation 1]}$$

Since the difference between the closed circuit voltage and the open circuit voltage is caused by the voltage drop in the internal resistance, the actual internal resistance of the battery cell can be calculated by dividing the difference between the closed circuit voltage and the open circuit voltage by the (quick) charging current.

In this case, the open circuit voltage ($OCV_{SOCx}$) may be measured within 1 second to 30 seconds, or within 1 second to 15 seconds, or within 1 second to 10 seconds, or within 2 seconds to 9 seconds, from the measurement starting time of the closed circuit voltage ($CCV_{SOCx}$).

The control portion 130 is configured to determine, from the internal resistance profile, a limit state of charge corresponding to each charging current (I) stored in the memory portion, and to establish a charging protocol based thereon.

The control portion 130 of the present invention may be configured to determine a value of the state of charge (SOCx) at the point in the internal resistance profile where the shape of the graph changes from flat to a downward trend, as the limit state of charge.

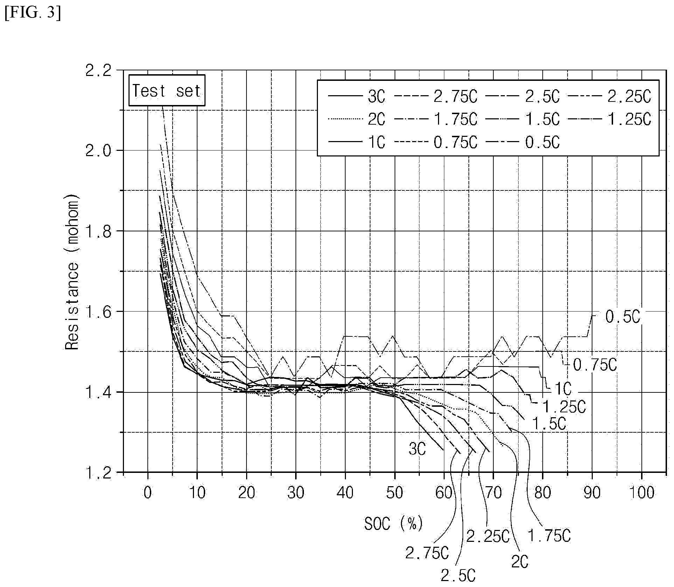

FIG. 3 illustrates an internal resistance profile according to a state of charge (SOCx) derived by measuring a closed circuit voltage ($CCY_{SOCx}$) according to a state of charge(SOCx) and an open circuit voltage ($OCV_{SOCx}$) according to a state of charge (SOCx), respectively, by charging current (I), calculating an internal resistance value ($R_{SOCx}$), and plotting an internal resistance value ($R_{SOCx}$) according to a state of charge (SOCx), according to an exemplary embodiment of the present invention.

Referring to FIG. 3, internal resistance profile plotting internal resistance values according to the state of charge is shown for a range of charging currents (I) from 0.5C to 3C, for various values of charging current set at intervals of 0.25C.

Looking at these internal resistance profiles, it can be observed that there is a point in the graph where the curve flattens out and then drops sharply. That is, for almost the entire range of charging currents (1C to 3C), there is a constant internal resistance value of about 1.4 mΩ, and then the internal resistance value changes to a decreasing trend, which can be considered the point where Li-plating occurs.

In the case of Li-plating, lithium ions are inserted into the graphite layer of the negative electrode during the charge rest period and are simultaneously coupled to the Li-plating portion. In other words, at the state of charge interval before Li-plating occurs, the lithium ions are inserted into the negative electrode and exist as a series resistance, but at the state of charge interval after Li-plating occurs, the case where lithium ions are inserted into the negative electrode and the case where Li-plating occurs form a parallel resistance, causing the overall resistance to drop. Therefore, in the internal resistance profile according to the state of charge, a decrease in the internal resistance value is an indicator that Li-plating has occurred.

Accordingly, the control portion 130 of the present invention determines the value of the state of charge (SOCx) at the point where the graph of the internal resistance profile by charging current changes from flat to a downward trend, as the limit state of charge. And after the control portion 130 determines the limit state of charge corresponding to each charge current I as described above, the control portion 130 can establish a charging protocol based on this.

The battery management system 100 according to the present invention has the effect that the measurement portion 110, the memory portion 120, and the control portion 130 can charge the battery cells according to a charging protocol that reflects the resistance of the large capacity battery cell 10 and the heat generated by quick charging.

Meanwhile, the control portion 130 may be configured to re-establish the charging protocol by periodically, during repeated charging and discharging of the battery cells, deriving a new limit state of charge corresponding to each charging current. This is to reflect battery cell aging over repeated charge and discharge cycles.

For example, the control portion 130 controls the measurement portion 110 to measure a closed circuit voltage ($CCV_{SOCx}$) according to a state of charge (SOCx) and an open circuit voltage ($OCV_{SOCx}$) according to a state of charge(SOCx), respectively, for the battery cell when charged with a different charging current (I), for every 100 cycles, controls the memory portion 120 to calculate an internal resistance value ($R_{SOCx}$) according to the state of charge by substituting the measured $CCV_{SOCx}$ and $OCV_{SOCx}$ into Equation 1 below, controls the memory portion 120 to collect and store an internal resistance profile plotting the internal resistance value according to the state of charge for each charging current I, and derive a new limit state of charge corresponding to each charging current from the internal resistance profile stored in the memory portion 120, and based on the above, establishes a new charging protocol reflecting aging.

Accordingly, the battery management system according to the present invention has the effect of non-destructively identifying the degree of battery cell aging even while the battery cell is in operation, and updating the charging protocol to reflect the aging of the battery cell.

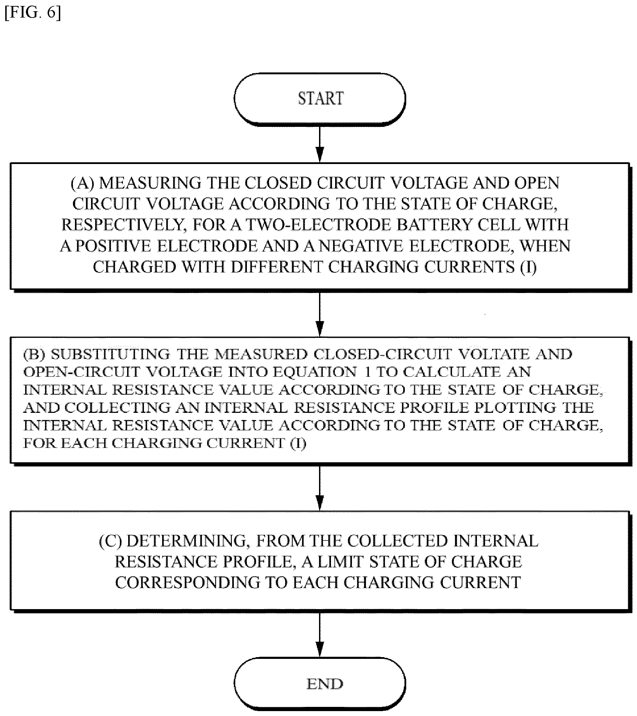

FIG. 6 is a flowchart of a method for establishing a charging protocol for a lithium secondary battery, according to an exemplary embodiment of the present invention.

(a) measuring the closed circuit voltage ($CCV_{SOCx}$) and open circuit voltage ($OCV_{SOCx}$) according to the state of charge (SOCx), respectively, for a two-electrode battery cell with a positive electrode and a negative electrode, when charged with different charging currents (I);
(b) substituting the measured $CCV_{SOCx}$ and $OCV_{SOCx}$ into Equation 1 below to calculate an internal resistance value ($R_{SOCx}$) according to the state of charge, and collecting an internal resistance profile plotting the internal resistance value ($R_{SOCx}$) according to the state of charge, for each charging current (I); and
(c) determining, from the collected internal resistance profile, a limit state of charge corresponding to each charging current.

Internal resistance value according to state of charge ($R_{SOCx}$)=($CCV_{SOCx}$ - $OCV_{SOCx}$)/I        [Equation 1]

In establishing a charging protocol according to the present invention, the limit state of charge may be the state of charge (SOC) value at the point where the shape of the internal resistance profile changes from flat to a downward trend.

And, in the process (a), the charging current (I) may be set at regular intervals, within a range of 0.2C to 6C, more specifically 0.33C to 6C, more specifically 0.5C to 5C. In this case, the interval may be from 0.1C to 1.0C.

In the prior art method of establishing a charging protocol, a three-electrode cell with a capacity of 50mAh has been manufactured in advance to derive the limit state of charge, and the Li-plating point according to the negative electrode potential has been derived as the limit state of charge, but the present invention does not require the manufacture of a three-electrode cell, and the limit state of charge can be derived directly through the calculation of the internal resistance value for a large capacity two-electrode battery cell with a capacity of 40 to 200Ah.

The method of establishing a charging protocol, according to exemplary embodiments, may further include mapping a charging protocol based on a limit state of charge by charging current.

The mapping process may be such that each charging current is mapped to charge at the corresponding charging current up to a limit state of charge, but the charging current decreases as the state of charge increases. For example, if the limit state of charge corresponding to a charging current of 3.0C may be SOC 40%, the limit state of charge corresponding to a charging current of 2.5C may be SOC 45%, the limit state of charge corresponding to a charging current of 2.0C may be SOC 55%, and the limit state of charge corresponding to a charging current of 5C is SOC 65%, it can be mapped so that charging can be performed with a charging current of 3.0C for SOC 40% and below, 2.5C for SOC 45% and below, 2.0C for SOC 55% and below, and 1.5C for SOC 65% and below.

Hereinafter, a battery management system of the present invention that derives a limit state of charge corresponding to a charging current and establishes a charging protocol according to the present invention will be described in detail with specific examples.

**Example 1**

For a battery cell with a capacity of 40 Ah and a SOC of 2.5%, charging at a charging current of 0.5 C, the measurement portion measured the closed circuit voltage ($CCV_{SOCx}$) and open circuit voltage ($OCV_{SOCx}$) of the battery cell at a state of charge interval of SOC 2.5%, and substituted the measurements into Equation 1 below to calculate the internal resistance value at that state of charge.

--> Internal resistance value according to state of charge ($R_{SOCx}$)=($CCV_{SOCx}$ - $OCV_{SOCx}$)/I        [Equation 1]

Then, by plotting the state of charge on the x-axis and the corresponding relationship of the internal resistance value on the y-axis, the internal resistance profile plotting the internal resistance value according to the state of charge as shown in FIG. 3 was stored in the memory portion.

The process was then repeated for each of the following charging currents: 0.75C, 1.0C, 1.25C, 1.5C, 1.75C, 2.0C, 2.25C, 2.5C, 2.75C, and 3.0C, and the internal resistance profile for each charging current was stored in memory portion.

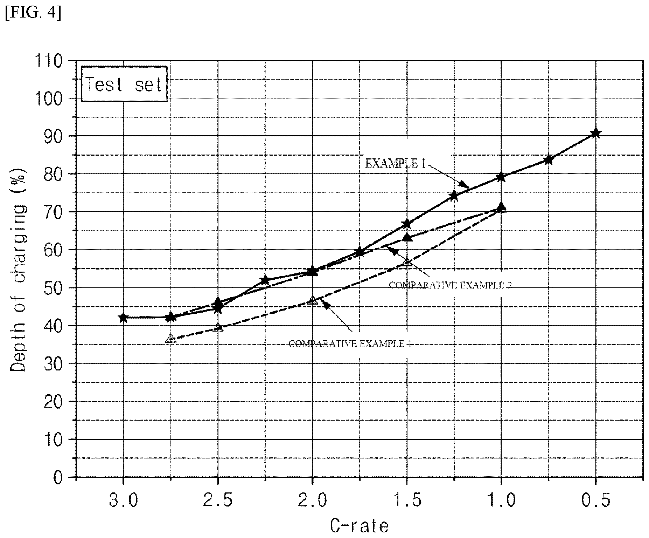

Then, the control portion determined, from the internal resistance profile according to the state of charge of FIG. 3 stored in the storage portion, the charging degree at the point where the graph shape changes from flat to a downward trend, as the limit state of charge by charging current, and the result is shown in FIG. 4 and Table 1.

[Table 1]

| Charging current (C-rate) | 3.0C | 2.75C | 2.5C | 2.25C | 2.0C | 1.75C | 1.5C | 1.25C | 1.0C |
|---|---|---|---|---|---|---|---|---|---|
| Limit state of charge (SOC) | 41.5% | 42% | 45% | 52% | 55% | 59% | 67% | 75% | 80% |

**Comparative Example 1**

Using a three-electrode cell, a conventional method of establishing a charging protocol, charge and discharge was performed at a temperature of 25 degrees Celsius to derive the limit state of charge by charging current, and the results are shown in Table 2 and FIG. 4. In this case, the limit state of charge was determined by measuring the negative electrode potential (CCV) according to the state of charge (SOC) of the three-electrode cell while charging at a charging current set at 0.25C intervals in the range of 1.0C to 2.75C for a mono-cell of 50mAh, and determining the state of charge at the point where the negative electrode potential begins to stabilize instead of dropping as the limit state of charge.

## Comparative Example 2

The limit state of charge by charging current was derived using the same method as in Comparative Example 1, except that the temperature was set to 35 degrees Celsius, and the results are shown in Table 2 and FIG. 4.

[Table 2]

| Temper ature (°C) | Charging current (C-rate) | 2.75C | 2.5C | 2.25C | 2.0C | 1.75C | 1.5C | 1.25C | 1.0C |
|---|---|---|---|---|---|---|---|---|---|
| 25 | Limit state of charge (SOC) | 36 | 40 | 43 | 46 | 51 | 56 | 64 | 71 |
| 35 | | 42 | 44 | 50 | 55 | 59 | 63 | 68 | 71 |

Comparing FIG. 4 with the results of Tables 1 and 2, it can be seen that the values of the limit state of charge by charging current according to the present invention are consistent or similar to the values of the limit state of charge by charging current derived using a conventional three-electrode cell at 35 degrees Celsius. Thus, it can be confirmed that the limit state of charge by charging current derived according to the present invention fully reflects the resistance of a large capacity battery cell and the heat generated by quick charging.

## Experimental Example 1

A battery cell (Preparation Example 1) used in Example 1 was prepared, and a battery cell (Preparation Example 2) in which the composition of the negative electrode was changed to provide excellent quick charging capability was prepared from the battery cell of Preparation Example 1.

For the battery cells of Preparation Example 1 and Preparation Example 2, a charging protocol was established by deriving the limit state of charge by charging current in the same manner as in the Example. As a result, a charging protocol was established in which the charging protocol for the battery cell of Preparation Example 1 required 28.4 minutes to charge (first charging protocol), and the charging protocol for the battery cell of Preparation Example 2 required 21.7 minutes to charge (second charging protocol).

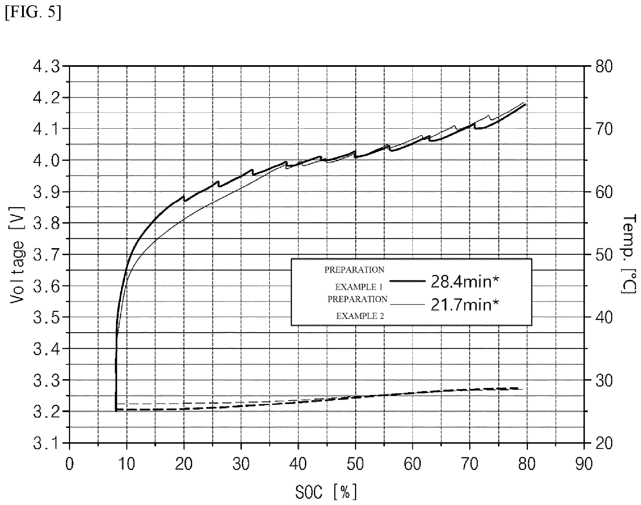

For the battery cell of Preparation Example 1, charging was performed according to the first charging protocol, and the open circuit voltage according to the state of charge was measured and the result is shown in FIG. 5. For the battery cell of Preparation Example 2, charging was performed according to the second charging protocol, and the open circuit voltage according to the state of charge was measured, and the result is shown in FIG. 5.

Referring to FIG. 5, it can be seen that the battery cell of Preparation Example 1 and the battery cell of Preparation Example 2 exhibit similar voltage profiles. Thus, it can be seen that the method of establishing a charging protocol according to the present invention has the effect of enabling the establishment of a protocol that uses a similar state of charge for battery cells with different electrode compositions.

## Experimental Example 2

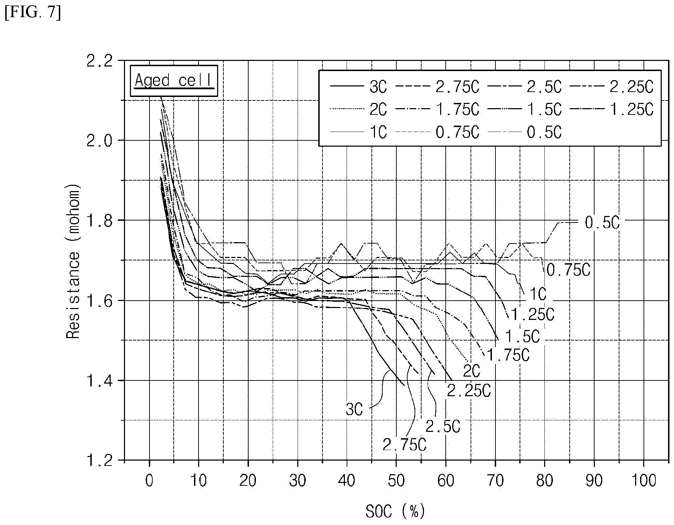

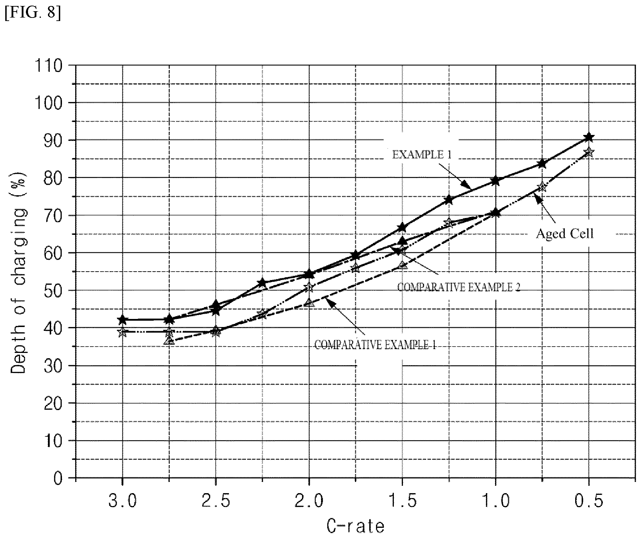

500 cycles of charge and discharge on the same battery cell as the battery cell used in Example 1 was performed, and for a battery cell (capacity: 40Ah) undergoing aging, the internal resistance profile according to the state of charge was derived under the same conditions and method, and the result is shown in FIG. 7. Then, in the internal resistance profile shown in FIG. 7, the state of charge at the point where the shape of the graph is flat and then decreases was determined as the limit state of charge for each charging current, and a graph in which the limit state of charge by charging current of the battery cell undergoing aging was added to the graph shown in FIG. 4 is shown in FIG. 8.

Comparing FIG. 7 with FIG. 3, the aged cell, which has been subjected to 500 cycles of charge and discharge and has undergone aging, has an increased internal resistance value from about 1.4 mΩ to about 1.6 mΩ, compared to the begin of life (BOL) battery cell (Example 1) that has not been subjected to repeated charge and discharge. This is thought to be reflecting aging due to repeated charge and discharge cycles. It was also found that the rate of increase of the internal resistance value varied depending on the charging current. Also, in FIG. 7, the x-axis coordinate (SOC) of the point at which the curve of the graph flattens and begins to decline is shifted more to the left than the x-axis coordinate of the point at which the curve of the graph flattens and begins to decline in FIG. 3. It can be seen that the limit state of charge by charging current decreases in cells in which aging has been progressed.

Therefore, the charging protocol establishment method of the present invention and the battery management system according to the present invention are expected to have the effect of updating a new charging protocol that reflects the degeneration of the battery cell during operation.

**Example 2**

A battery cell (capacity: 40Ah) having the same specification as the battery cell used in Example 1 was connected to the electrochemical charger and discharger. Based on the limit state of charge by charging current listed in Table 1 of Example 1, the charging protocol was mapped as shown in Table 3 below, the battery cell was fully charged to SOC 100% according to the mapped charging protocol, and the fully charged battery cell was fully discharged to SOC 0% with a constant current of 0.33C.

[Table 3]

| SOC 0% ~ SOC 40% | SOC 40% ~ SOC 50% | SOC 50% ~ SOC 65% | SOC 65% ~ SOC 80% | SOC 80%~SOC 100% |
|---|---|---|---|---|
| 3.0C | 2.25C | 1.5C | 1.0C | 0.33C |

**Comparative Example 3**

A battery cell (capacity: 40Ah) with the same specification as the battery cell used in Example 1 was connected to the electrochemical charger and fully charged to SOC 100% with a constant current of 0.33C, and the fully charged battery cell was fully discharged to SOC 0% with a constant current of 0.33C.

**Experimental Example 2: Measuring charge and discharge time**

For each case of charging according to the method of Example 2 and charging according to the method of Comparative Example 3, the time required for charging was measured and the results are shown in Table 4.

**Experimental Example 3: Evaluating capacity retention rate**

Charging and discharging was performed according to the method of Example 2 and Comparative Example 3, respectively, but 200 cycles of charging and discharging were repeated, and then the capacity retention rate calculated according to Equation 1 below was shown in Table 4.

(Discharge capacity at 200 cycles $\times$ 100)/ Discharge capacity at first cycle                    Equation 1:

[Table 4]

|  | Example 2 | Comparative Example 3 |
|---|---|---|
| Charging time(min) | 62 | 180 |
| Capacity retention rate (%) | 89 | 90 |

Referring to Table 4, when charging according to the charging protocol according to Example 2, the time required for charging was significantly reduced compared to charging according to the charging method according to Comparative Example 3. Furthermore, when charging according to the charging protocol according to Example 2, the capacity retention rate was equivalent to that of charging according to the charging method according to Comparative Example 3, thus confirming that the charging protocol derived according to the present invention does not cause capacity aging of the battery cell.

[Reference numerals]

1: BATTERY PACK
10: BATTERY CELL
100: BATTERY MANAGEMENT SYSTEM
110: MEASUREMENT PORTION
120: MEMORY PORTION

130: CONTROL PORTION
200: CHARGING DEVICE

**Claims**

1. A battery management system comprising:

   a measurement portion configured to measure, for a two-electrode battery cell having a positive electrode and a negative electrode, a closed circuit voltage ($CCV_{SOCx}$) and an open circuit voltage ($OCV_{SOCx}$), respectively, according to a state of charge (SOCx), when charged with different charging currents (I);
   a memory portion configured to collect and store internal resistance profiles plotting the internal resistance value ($R_{SOCx}$) according to the state of charge for each charging current (I), by substituting the measured $CCV_{SOCx}$ and $OCV_{SOCx}$ into Equation 1 below to calculate the internal resistance value ($R_{SOCx}$) according to the state of charge; and
   a control portion configured to determine, from the internal resistance profiles, limit state of charges for each charging current, and to establish a charging protocol based thereon.

   [Equation 1]

   $$\text{Internal resistance value according to state of charge } (R_{SOCx}) = (CCV_{SOCx} - OCV_{SOCx})/I$$

2. The battery management system of claim 1, wherein the control portion is configured to determine a state of charge (SOCx) value, as a limit state of charge, at a point where the graphical shape of the internal resistance profile changes from flat to a downward trend.

3. The battery management system of claim 1, wherein the control portion is configured to re-establish the charging protocol by periodically, during repeated charging and discharging of the battery cells, deriving new limit state of charges for each charging current.

4. The battery management system of claim 1, further comprising a connecting portion configured to connect with a charging device to supply a charging current to the battery cell according to the charging protocol established by the control portion.

5. The battery management system of claim 1, wherein the measurement portion is configured to measure status information of the battery cell comprising at least one of a voltage of the battery cell and a state of charge.

6. The battery management system of claim 1, wherein the charging current (I) is selected from a range of 0.33C to 6.0C.

7. A battery pack comprising a battery management system according to claim 1.

8. The battery pack of claim 7, wherein the battery pack comprises a plurality of battery cells having a capacity of 40 to 200 Ah.

9. A method for establishing a lithium secondary battery charging protocol comprising:

   (a) measuring a closed circuit voltage ($CCV_{SOCx}$) and an open circuit voltage ($OCV_{SOCx}$) according to the state of charge (SOCx), respectively, for a two-electrode battery cell with a positive electrode and a negative electrode, when charged with different charging currents (I);
   (b) substituting the measured $CCV_{SOCx}$ and $OCV_{SOCx}$ into Equation 1 below to calculate an internal resistance value ($R_{SOCx}$) according to the state of charge, and collecting internal resistance profiles plotting the internal resistance value ($R_{SOCx}$) according to the state of charge, for each charging current (I); and
   (c) determining, from the collected internal resistance profiles, a limit state of charges corresponding to each charging current;

[Equation 1]

Internal resistance value according to state of charge $(R_{SOCx}) = (CCV_{SOCx} - OCV_{SOCx})/I$

10. The method for establishing a lithium secondary battery charging protocol of claim 9, wherein in process (c), the limit state of charge is determined as a state of charge (SOC) value at a point where the graphical shape of the internal resistance profile changes from flat to a downward trend.

11. The method for establishing the lithium secondary battery charging protocol of claim 9, wherein the two-electrode battery cell has a capacity of 40 to 200 Ah.

12. The method for establishing the lithium secondary battery charging protocol of claim 9, wherein in process (a), the charging current (I) is selected from the range of 0.33C to 6.0C.

13. The method for establishing the lithium secondary battery charging protocol of claim 12, wherein in process (a), the charging current (I) is set at an interval of 0.1C to 1.0C.

14. The method for establishing the lithium secondary battery charging protocol of claim 9, further comprising mapping a charging protocol based on a limit state of charge by charging current, wherein
the mapping process maps so that each charging current is charged at a corresponding charging current up to a limit state of charge, but the charging current decreases as the state of charge increases.

[FIG. 1]

```
                              1
 ┌─────────────────────────────────────────────────────────────┐
 │                     BATTERY PACK                              │
 │        100                                                    │
 │   ┌──────────────────────────────┐                           │
 │   │  BATTERY MANAGEMENT SYSTEM    │                           │
 │   │                               │                           │
 │   │  ┌────────────────────┐       │   ┌─────────────────┐     │
 │   │  │ MEASUREMENT PORTION │~110  │   │  BATTERY CELL   │~10  │
 │   │  └────────────────────┘       │   └─────────────────┘     │
 │   │                               │                           │
 │   │  ┌────────────────────┐       │                           │
 │   │  │   MEMORY PORTION    │~120  │                           │
 │   │  └────────────────────┘       │                           │
 │   │                               │                           │
 │   │  ┌────────────────────┐       │                           │
 │   │  │  CONTROL PORTION    │~130  │                           │
 │   │  └────────────────────┘       │                           │
 │   └──────────────────────────────┘                           │
 └─────────────────────────────────────────────────────────────┘

                                               ┌─────────────────┐
                                               │ CHARGING DEVICE │~200
                                               └─────────────────┘
```

[FIG. 2]

[FIG. 3]

[FIG. 4]

[FIG. 5]

[FIG. 6]

```
                    ╭──────────────╮
                    │    START     │
                    ╰──────────────╯
                           │
                           ▼
┌─────────────────────────────────────────────────────────┐
│      (A) MEASURING THE CLOSED CIRCUIT VOLTAGE AND OPEN   │
│     CIRCUIT VOLTAGE ACCORDING TO THE STATE OF CHARGE,    │
│    RESPECTIVELY, FOR A TWO-ELECTRODE BATTERY CELL WITH   │
│     A POSITIVE ELECTRODE AND A NEGATIVE ELECTRODE, WHEN  │
│        CHARGED WITH DIFFERENT CHARGING CURRENTS (I)      │
└─────────────────────────────────────────────────────────┘
                           │
                           ▼
┌─────────────────────────────────────────────────────────┐
│  (B) SUBSTITUTING THE MEASURED CLOSED-CIRCUIT VOLTATE AND│
│  OPEN-CIRCUIT VOLTAGE INTO EQUATION 1 TO CALCULATE AN    │
│  INTERNAL RESISTANCE VALUE ACCORDING TO THE STATE OF     │
│  CHARGE, AND COLLECTING AN INTERNAL RESISTANCE PROFILE   │
│  PLOTTING THE INTERNAL RESISTANCE VALUE ACCORDING TO THE │
│  STATE OF CHARGE, FOR EACH CHARGING CURRENT (I)          │
└─────────────────────────────────────────────────────────┘
                           │
                           ▼
┌─────────────────────────────────────────────────────────┐
│       (C) DETERMINING, FROM THE COLLECTED INTERNAL       │
│      RESISTANCE PROFILE, A LIMIT STATE OF CHARGE         │
│       CORRESPONDING TO EACH CHARGING CURRENT             │
└─────────────────────────────────────────────────────────┘
                           │
                           ▼
                    ╭──────────────╮
                    │     END      │
                    ╰──────────────╯
```

[FIG. 7]

[FIG. 8]

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020220147912